# EUROPÄISCHE PATENTSCHRIFT

(11) **EP 3 756 022 B1**
(45) Veröffentlichungstag und Bekanntmachung des Hinweises auf die Patenterteilung: **02.09.2026**
(21) Anmeldenummer: 19714984.2
(22) Anmeldetag: 21.02.2019
(51) Int. Cl.: G01R 31/327

(54) **VERFAHREN ZUM BESTIMMEN EINES BETRIEBSZUSTANDS EINES ELEKTRISCHEN BETRIEBSMITTELS UND ANORDNUNG**
METHOD FOR DETERMINING AN OPERATING STATE OF AN ELECTRICAL APPARATUS, AND ASSEMBLY
PROCÉDÉ DE DÉTERMINATION D'UN ÉTAT DE FONCTIONNEMENT D'UN ÉQUIPEMENT ÉLECTRIQUE ET DISPOSITIF

(30) Priorität: 21.02.2018 DE 102018103901
(43) Veröffentlichungstag der Anmeldung: 30.12.2020
(73) Patentinhaber: Hochschule für Technik und Wirtschaft Berlin, 10318 Berlin (DE)
(72) Erfinder: GRÄF, Thomas, 12621 Berlin (DE)
(74) Vertreter: Bittner, Thomas L.
(86) Internationale Anmeldenummer: PCT/DE2019/100165
(87) Internationale Veröffentlichungsnummer: WO 2019/161849

(56) Entgegenhaltungen:
- WO-A1-2016/192946
- DE-A1- 102011 002 870
- US-A1- 2011 213 744
- US-A1- 2017 184 675

## Beschreibung

Die Erfindung betrifft ein Verfahren zum Bestimmen eines Betriebszustands eines elektrischen Betriebsmittels und eine Anordnung.

### Hintergrund

Die Messung von Temperaturen erfolgt in der Regel mit Thermoelementen oder Widerstandelementen, die an eine Messstelle angebracht werden. Auch der Einsatz von optischen Sensoren oder Messverfahren, Pyrometer, oder der Einsatz faseroptischer Messtechnik ist möglich. Im Bereich der elektrischen Energietechnik ist jedoch nicht immer eine Einsatzmöglichkeit von entsprechender Sensorik gegeben, da häufig Einschränkungen hinsichtlich der Messsensorik, der Anbringung der Sensorik, der Beeinflussung des Messortes, bedingt durch das Fertigungsverfahren des Betriebsmittels oder der Sensorik, der Energieversorgung des Sensors auftreten.

In elektrischen Betriebsmitteln ist aufgrund von anliegender Hochspannung, nicht gegebener Zugänglichkeit, Einschränkungen oder mangels fehlender Messmöglichkeit eine exakte Temperaturmessung unter Berücksichtigung parasitärer Effekte wie Skineffekt, Proximityeffekt, Wirbelstromverluste, schwankende Umgebungsbedingungen und -temperaturen, Alterung oder unbekannter, interner Wärmeleitung schwierig oder gar nicht ausführbar.

Es stehen verschiedene Arten von Sensoren und physikalische Verfahren zur Verfügung, die auch direkt im Bereich Hochspannung führender Leiter und Betriebsmittel eingesetzt werden können. Damit ergibt sich die Möglichkeit der direkten Temperaturbestimmung am Fixpunkt eines eingesetzten Temperatursensors. Mittlerweile stehen auch linienförmige Temperatursensoren in Form von faseroptischen Sensoren zur Verfügung, die eine ortsgenaue Temperaturmessung ermöglichen. Allen bislang durchgeführten Temperaturmessungen ist gemein, dass diese zwar die lokale Temperatur erfassen, allerdings eine Ableitung, warum eine entsprechende Temperatur auftritt nicht erlauben. Dazu müssen weitere Prozessparameter hinkommen, um hier eine weitergehende Analyse und Zustandsbeschreibung zu ermöglichen.

Das Dokument DE 10 2014 101 156 A1 beschreibt eine Vorrichtung und ein Verfahren zum Bestimmen eines Messwertes in einer elektrischen Anlage.

Das Dokument DE 10 2015 100 399 A1 beschreibt eine Anordnung bestehend aus einer Schmelzsicherung und einer an der Schmelzsicherung angeordneten Messeinrichtung sowie Messeinrichtung.

Das Dokument US 2017/184675 A1 betrifft ein System mit mindestens einem Leistungsschalter und einem Prognose- und Gesundheitsüberwachungssystem (PHM-System). Das PHM-System kann mindestens ein Messgerät umfassen, das mindestens einen dem Leistungsschalter zugeordneten Parameter misst. Das PHM-System kann auch eine Steuerung umfassen, die von der mindestens einen Messvorrichtung durchgeführte Messungen empfängt und die Messungen analysiert, um eine Leistung des Leistungsschalters zu bewerten. Die Messungen können durchgeführt werden, während der Leistungsschalter in Betrieb ist.

Gegenstand des Dokuments WO 2016/192946 A1 ist ein Verfahren für einen Betrieb einer elektrischen Anlage mit einem Gehäuse und stromleitenden Komponenten, bei dem die Gehäusetemperatur und die durch die stromleitenden Komponenten fließende Stromstärke bestimmt werden und mittels eines thermischen Modells unter Berücksichtigung der Stromstärke und der Gehäusetemperatur die maximal zulässige Strombelastbarkeit berechnet wird, bei der keine thermische Überlastung der Anlage auftritt. Ferner ist eine entsprechende Anordnung für einen Betrieb einer elektrischen Anlage beschrieben.

Das Dokument US 2011/213744 A1 beschreibt Systeme und Verfahren zur Überwachung des Anlagenzustands in Umspannwerkanlagen. Ein Verfahren zum Erfassen des Verhaltens in elektrischen Umspannwerkgeräten bereitgestellt kann das Empfangen von Echtzeitdaten umfassen, die einer Vielzahl von Parametern zugeordnet sind, die der Unterstationsausrüstung zugeordnet sind, das Speichern mindestens eines Teils der Echtzeitdaten über einen Zeitraum, wobei die gespeicherten Daten historische Daten umfassen, das Vergleichen der Echtzeit- und historischen Daten und Generieren eines Berichts, der zumindest teilweise auf einem Vergleich der Echtzeitdaten und der historischen Daten basiert.

### Zusammenfassung

Aufgabe der Erfindung ist es, ein Verfahren zum Bestimmen eines Betriebszustands eines elektrischen Betriebsmittels und eine Anordnung anzugeben, mit denen der Betriebszustand in verschiedenen Anwendungssituationen zuverlässig bestimmt werden kann. Insbesondere soll eine Bestimmung eines Auslastungsgrads des elektrischen Betriebsmittels ermöglicht sein.

Zur Lösung sind ein Verfahren zum Bestimmen eines Betriebszustands eines elektrischen Betriebsmittels und eine Anordnung nach den unabhängigen Ansprüchen 1 und 10 geschaffen. Ausgestaltungen sind Gegenstand von abhängigen Unteransprüchen.

Nach einem Aspekt ist ein Verfahren zum Bestimmen eines Betriebszustands eines elektrischen Betriebsmittels geschaffen. Das Verfahren sieht Folgendes vor: Messen von zeitabhängigen Strommesswerten für eine Stromamplitude eines elektrischen eines Stromflusses in einem Schaltelement eines elektrischen Betriebsmittels; Messen von zeitabhängigen Temperaturmesswerten für eine Temperaturamplitude für das Schaltelement und Bestimmen eines Betriebszustands für das elektrische Betriebsmittel. Beim Bestimmen des Betriebszustandes ist weiterhin Folgendes vorgesehen: die zeitabhängigen Strommesswerte werden mit zeitabhängigen Stromvergleichswerten verglichen, die jeweils mindestens einem Betriebszustand aus einer Gruppe von verschiedenen Betriebszuständen des elektrischen Betriebsmittels zugeordnet sind; die zeitabhängigen Temperaturmesswerte werden mit zeitabhängigen Temperaturvergleichswerten verglichen, die jeweils dem mindestens einen oder mindestens einem anderen Betriebszustand aus der Gruppe von verschiedenen Betriebszuständen des elektrischen Betriebsmittels zugeordnet sind; und Bestimmen eines ausgewählten Betriebszustands aus der Gruppe von verschiedenen Betriebszuständen als Betriebszustand des elektrischen Betriebsmittels, wenn die zeitabhängigen Strommesswerte zeitabhängigen Stromvergleichswerten und die zeitabhängigen Temperaturmesswerte zeitabhängigen Temperaturvergleichswerten entsprechen, die jeweils dem ausgewählten Betriebszustand zugeordnet sind.

Nach einem weiteren Aspekt ist eine Anordnung geschaffen, die Folgendes aufweist: ein elektrisches Betriebsmittel, welches ein Schaltelement aufweist; eine Strommesseinrichtung, die eingerichtet ist, zeitabhängige Strommesswerte für eine Stromamplitude eines elektrischen Stromflusses in dem Schaltelement zu erfassen; eine Temperaturmesseinrichtung, die eingerichtet ist, zeitabhängige Temperaturmesswerte für eine Temperaturamplitude für das Schaltelement zu erfassen; und eine Auswerteinrichtung, die wenigstens zum Empfangen von Messdaten mit der Strommesseinrichtung und der Temperaturmesseinrichtung verbunden und eingerichtet ist, einen Betriebszustand für das elektrische Betriebsmittel zu bestimmen. Beim Bestimmen des Betriebszustandes ist weiterhin Folgendes vorgesehen: die zeitabhängigen Strommesswerte werden mit zeitabhängigen Stromvergleichswerten verglichen, die jeweils mindestens einem Betriebszustand aus einer Gruppe von verschiedenen Betriebszuständen des elektrischen Betriebsmittels zugeordnet sind; die zeitabhängigen Temperaturmesswerte werden mit zeitabhängigen Temperaturvergleichswerten verglichen, die jeweils dem mindestens einen oder mindestens einem anderen Betriebszustand aus der Gruppe von verschiedenen Betriebszuständen des elektrischen Betriebsmittels zugeordnet sind; und Bestimmen eines ausgewählten Betriebszustands aus der Gruppe von verschiedenen Betriebszuständen als Betriebszustand des elektrischen Betriebsmittels, wenn die zeitabhängigen Strommesswerte zeitabhängigen Stromvergleichswerten und die zeitabhängigen Temperaturmesswerte zeitabhängigen Temperaturvergleichswerten entsprechen, die jeweils dem ausgewählten Betriebszustand zugeordnet sind.

Das Messen der zeitabhängigen Temperaturmesswerte kann eine kontaktbehaftete Temperaturmessung an dem Schaltelement aufweisen.

Das Messen der zeitabhängigen Temperaturmesswerte kann eine kontaktfreie Temperaturmessung in einer Umgebung benachbart zu dem Schaltelement aufweisen.

Die zeitabhängigen Strommesswerte können mit simulierten zeitabhängigen Stromvergleichswerten verglichen werden, die mittels eines Simulationsmodells für das elektrische Betriebsmittel bestimmt werden.

Die zeitabhängigen Temperaturmesswerte können mit simulierten zeitabhängigen Temperaturvergleichswerten verglichen werden, die mittels des Simulationsmodells für das elektrische Betriebsmittel bestimmt werden.

Es kann vorgesehen sein, den Betriebszustand eines mit einer Schaltanlage ausgeführten elektrischen Betriebsmittels zu bestimmen.

Als Betriebszustand kann ein Kurzschluss bestimmt werden, wenn die zeitabhängigen Temperaturmesswerte einen schnellen Temperaturanstieg anzeigen. Dieses bedeutet, dass beispielweise Temperaturgradienten von wenigstens bis zu etwa 100°c / s erreicht werden. Der Temperaturanstieg kann durch die Wärmekapazität der Messstelle beeinflusst werden.

Als Betriebszustand ein Wartungs- und / oder Reinigungsbedarf bestimmt wird, wenn die zeitabhängigen Temperaturmesswerte bei gleichbleibenden zeitabhängigen Strommesswerten eine Temperaturerhöhung anzeigen.

Es kann vorgesehen sein, für eine weitere physikalische Messgröße zeitabhängige Messwerte zu erfassen und beim Bestimmen des Betriebszustands mit zeitabhängigen Vergleichswerten zu vergleichen.

In Verbindung mit der Anordnung können die vorangehend im Zusammenhang mit dem Verfahren zum Bestimmen des Betriebszustands des elektrischen Betriebsmittels erläuterten Ausgestaltungen entsprechend vorgesehen sein.

Das oder die Schaltelemente können ein oder mehrere der folgenden Elemente aufweisen: Leistungsschalter, Lasttrennschalter, Sicherungslasttrennschalter, Hochspannungs-Hochleistungssicherungen, Niederspannungs-Hochleistungssicherungen, Erder, Kurzschlussstrombegrenzer, Recloser und / oder Schütze sein.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Darstellung einer Anordnung mit einem elektrischen Betriebsmittel;
- Fig. 2: eine schematische Darstellung für ein Verfahren zum Bestimmen eines Betriebszustands für das elektrische Betriebsmittel;
- Fig. 3: eine schematische Darstellung zu physikalischen Grundlagen betreffend eine Temperaturänderung an einem Körper;
- Fig. 4: eine schematische Darstellung zu einer Schaltanlage;
- Fig. 5: eine schematische grafische Darstellung für einen zeitabhängigen Verlauf von Temperatur und Strom für eine kurze Zeitperiode ;
- Fig. 6: eine schematische grafische Darstellung für einen zeitabhängigen Verlauf von Temperatur und Strom für eine längere Zeitperiode als in Fig. 5;
- Fig. 7: eine schematische grafische Darstellung für einen zeitabhängigen Verlauf von Temperatur und Strom für eine lange Zeitperiode von bis zu Jahren;
- Fig. 8: eine schematische grafische Darstellung für einen zeitabhängigen Verlauf von Temperatur und Strom für eine Zeitperiode von mehreren Stunden;
- Fig. 9: eine schematische grafische Darstellung für einen zeitabhängigen Verlauf von Temperatur und Strom für eine weitere kurze Zeitperiode;
- Fig. 10: eine schematische grafische Darstellung für die ortsaufgelöste thermische Verteilung entlang einer Strombahn, die neben dem zeitaufgelösten Stromverlauf betrachtet werden kann;
- Fig. 11: eine schematische grafische Darstellung für einen zeitabhängigen Verlauf von Temperatur und Strom für eine weitere lange Zeitperiode von bis zu Jahren;
- Fig. 12: eine schematische grafische Darstellung für einen zeitabhängigen Verlauf von Temperatur und Strom für eine andere lange Zeitperiode von bis zu Jahren; und
- Fig. 13: eine schematische grafische Darstellung für einen zeitabhängigen Verlauf von Temperatur und Strom für eine andere kurze Zeitperiode, wobei Zeitkonstanten T₁ und T₂ gezeigt sind.

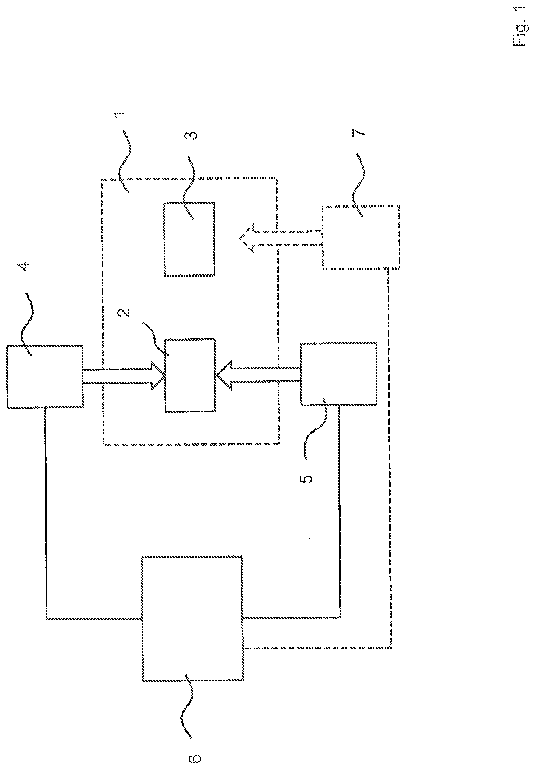

Fig. 1 zeigt eine schematische Darstellung einer Anordnung zum Bestimmen eines Betriebszustands eines elektrischen Betriebsmittels 1. Bei dem elektrischen Betriebsmittel kann es **sich zum** Beispiel um eine Schaltanlage handeln. Hierbei handelt es sich um eine Anlage, in der elektrische Energie verteilt oder umgespannt wird.

Das elektrische Betriebsmittel 1 weist Schaltelemente 2 und 3 auf. Es ist eine Temperaturmesseinrichtung 4 vorgesehen, die eingerichtet ist, für das Schaltelement 2 zeitaufgelöst eine Betriebstemperatur zu erfassen. Hierbei kann eine kontaktbehaftete Messung oder alternativ eine Messung vorgesehen sein, bei der die Temperaturmesseinrichtung 4 nicht mit dem Schaltelement 2 in Kontakt ist, sondern benachbart zu dem Schaltelement 2 eine Temperatur misst. Mithilfe der Temperaturmesseinrichtung 4 werden Temperaturmesswerte (Amplitude in Abhängigkeit von der Zeit) für das Schaltelement 2 über einen Messezentrum erfasst.

Weiterhin ist eine Strommesseinrichtung 5 vorgesehen, mit der zeitabhängig die Amplitude eines durch das Schaltelement 2 fließenden Stroms gemessen wird.

Schaltelemente können zum Beispiel Leistungsschalter, Lasttrennschalter, Sicherungslasttrennschalter, Hochspannungs-Hochleistungssicherungen, Niederspannungs-Hochleistungssicherungen, Erder, Kurzschlussstrombegrenzer, Recloser und / oder Schütze sein.

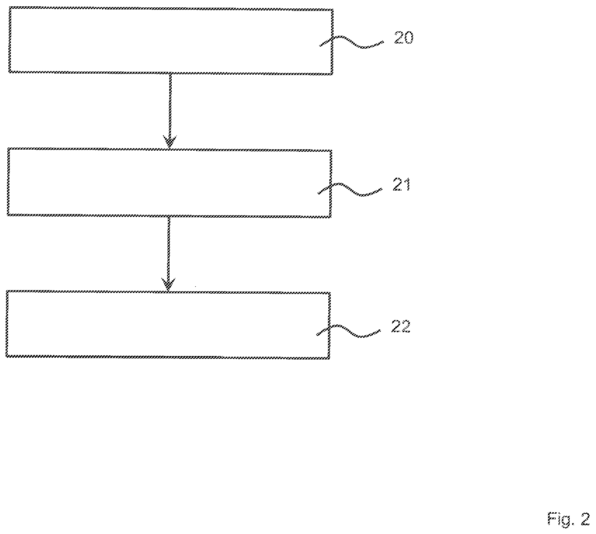

Die mithilfe der Temperaturmesseinrichtung 4 und der Strommesseinrichtung 5 erfassten Messwerte werden nach dem Messen (vgl. Schritte 20, 21 in Fig. 2) in einer Verarbeitungs- oder Auswerteeinrichtung 6 ausgewertet, um einmal oder mehrmals einen aktuellen Betriebszustand für das elektrische Betriebsmittel 1 zu bestimmen. Hierzu werden im Schritt 22 gemäß Fig. 2 die Temperaturmesswerte und die Strommesswerte jeweils mit Temperaturvergleichswerten und Stromvergleichswerten verglichen, die jeweils mindestens einem Betriebszustand aus einer Gruppe von verschiedenen Betriebszuständen für das elektrische Betriebsmittel 1 zugeordnet sind. Auf diese Weise werden sowohl die Temperaturmesswerte als auch die Strommesswerte herangezogen, um den Betriebszustand des elektrischen Betriebsmittels 1 zu bestimmen. Hierbei kann vorgesehen sein, dass die Temperaturvergleichswerte und die Stromvergleichswerte auf Basis eines Simulationsmodells für das elektrische Betriebsmittel 1 bestimmt sind. Das Bestimmen und Analysieren von Simulationsmodellen ist als solches in verschiedenen Ausführungen bekannt (vgl. zum Beispiel: "Real time Thermal Rating (RTTR) - Ein Management- und Optimierungstool der Energieübertragung in Hochspannungskabeln", Kuschei et al., Elektrizitätswirtschaft, Sonderdruck Nr. 4935, Jahrgang 1999 (2000), Heft 26; "Thermal Simulation of Switchgear", Paulke et al., Rockwell Automation; P. Steinhäuser, VT-GmbH. IEEE 0-7803-6667-0101).

Die Temperaturvergleichswerte und die Stromvergleichswerte sind jeweils mindestens einem Betriebszustand des elektrischen Betriebsmittels 1 zugeordnet. Hierbei können gleiche Stromvergleichswerte und / oder gleiche Temperaturvergleichswerte jeweils mehreren Betriebszuständen des elektrischen Betriebsmittels 1 zugeordnet sein, wobei sich zwei Betriebszustände des elektrischen Betriebsmittels 1 wenigstens durch verschiedene Temperaturvergleichswerte oder verschiedene Stromvergleichswerte unterscheiden.

Eine oder mehrere weitere physikalische Messgrößen können für das elektrische Betriebsmittel 1 bzw. das Schaltelement 2 erfasst und mit zugeordneten Vergleichswerten verglichen werden, um dies beim bestimmen des Betriebszustands zu berücksichtigen. In Fig. 1 ist dies schematisch mittels einer weiteren Messeinrichtung 7 gezeigt.

Nachfolgend werden zunächst physikalische Grundlagen erläutert, welche für die Messungen beim Bestimmen des Betriebszustands in den verschiedenen Ausführungen von Bedeutung sein können.

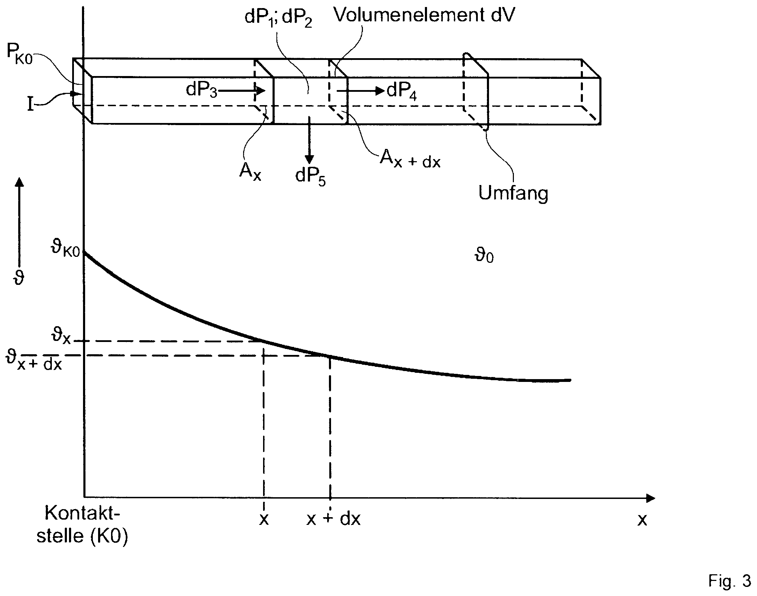

Eine Temperaturänderung tritt ein, wenn die Summe der wirkenden Energien nicht mehr Null ergibt. Mathematisch lässt sich das wie folgt beschreiben, wobei auf eine schematische Darstellung in Fig. 3 Bezug genommen wird. Die in einem Volumenelement erzeugte Leistung ist ${dP}_{1} = k ⋅ {I}^{2} {ρA}^{- 1} dx$
P1 : im Volumenelement erzeugte Leistung
k : Konstante
l : Strom
A : Fläche
ρ : spezifischer Widerstand

Die in einem Volumenelement gespeicherte Leistung ist beschrieben mit ${dP}_{2} = A ⋅ {c}_{P} ⋅ δ ⋅ \frac{\partial θ}{\partial t} dx$
A : Fläche
cp : spezifische Wärmekapazität
δ : Dichte
$\frac{\partial θ}{\partial t} dx$ : Temperaturänderung über der Zeit am Ort x

Die in ein Volumenelement an der Stelle x hineingehende Leistung ${dP}_{3} = - λ ⋅ {A}_{x} ⋅ \frac{\partial θ}{\partial x}$
λ : Wärmeleitfähigkeit
Ax : Fläche an der Stelle x
$\frac{\partial θ}{\partial x}$ : Temperaturänderung an der Stelle x

Die aus einem Volumenelement an der Stelle x hinausgeleitete Leistung ${dP}_{4} = - λ ⋅ {A}_{x + dx} ⋅ \frac{\partial θ}{\partial x} \left(θ+\frac{\partial θ}{\partial x}dx\right)$
ϑ : Temperatur
$\frac{\partial θ}{\partial x}$ : Temperaturänderung an der Stelle x

Vom Volumenelement über die Oberfläche Udx (U Umfang) durch Wärmeübergang abgegebene Leistung ${dP}_{5} = α ⋅ U \left(θ-{θ}_{0}\right) dx$ α: Wärmeübergangswiderstand; U : Umfang.

Für die Leistungsbilanz des Volumenelements eines gestreckten Leiters gilt: ${dP}_{1} - {dP}_{2} + {dP}_{3} - {dP}_{4} + {dP}_{5} = 0$

Die oben dargestellten Zusammenhänge zeigen allerdings, dass für die Bestimmung der Temperatur und deren Bewertung hinsichtlich der Wirkung an einer spezifischen Stelle neben der Messung selbst weitere Parameter wie Stromfluss sowie umgebende Strömung und Wärmeleitung bekannt sein müssen.

In dem vorgeschlagenen Verfahren werden zusätzlich der Strom in einem Leiter (Schaltelement) sowie wahlweise die Umgebungstemperatur außerhalb des Messortes berücksichtigt.

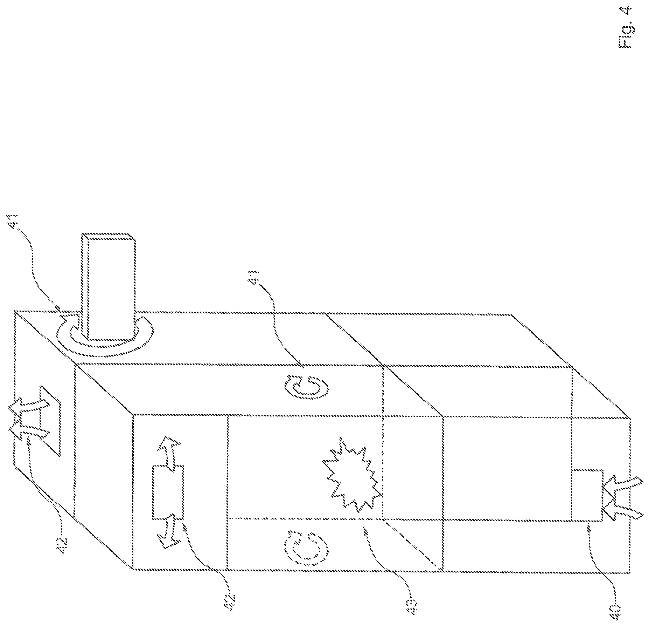

Als Beispiel soll eine vereinfachte Darstellung einer Schaltanlage dienen. Diese lässt sich abstrahieren, indem lediglich folgende Annahmen getroffen werden. Schaltanlagen haben Wärmequellen in einem Gehäuse. Gehäuse bestehen aus Metall oder Kunststoff und müssen Wärme an die Umgebung abgeben. Zur Sicherstellung des Wärmehaushalts im Gehäuse muss eine Be- und Entlüftung (vgl. Fig. 4, Bezugszeichen 40 und 42) im Gehäuse integriert sein oder eine ausreichende wärmeabgebende Oberfläche vorhanden sein.

Die notwendigen Öffnungen müssen entsprechend abgedeckt sein, so dass keine Kleintiere, Verunreinigungen eindringen können und der Berührungsschutz sichergestellt ist. Dabei beeinflussen diese maßgeblich den internen Wärmehaushalt. Sofern große Ströme in oder aus dem Gehäuse geleitet werden, treten Induktionsströme, Wirbelströme (Fig. 4, Bezugszeichen 41), im metallischen Gehäuse auf, die dieses lokal erwärmen. Dieses ist bislang nicht mit Simulationen mit ausreichender Genauigkeit nachbildbar.

Sofern die Temperatur innerhalb der Schaltanlage an einem Ort 40 gemessen wird, ist keine Aussage möglich, ob zum Beispiel ein benachbarter Ort 41 eine höhere oder niedrigere Temperatur erfährt, wodurch die Temperatur an diesem Ort 41 beeinflusst wurde und welche weiteren Effekte zur Änderung der Temperatur führen. So kann es durchaus vorkommen, dass sich verschiedene temperaturbestimmende Effekte überlagern. Die Temperaturbestimmung ist daher als kausale Zustandsgröße anzusehen.

Aus dem Stand der Technik bekannte Verfahren zur theoretischen Bestimmung von Temperaturen beruhen auf Simulationsrechnungen, entweder nach FEM-Methoden, BEM oder dgl. Ein bekanntes Verfahren ist die Wärmenetzmethode, die das Ähnlichkeitsprinzip der Widerstands-Kondensatorladung und -entladung für die Wärmeleitung nutzt. Parasitäre Wärmeeffekte wie die durch Wirbelströme oder sich zusetzende Be- und Entlüftungsöffnungen oder schwankende Umgebungstemperaturen werden hierbei nicht berücksichtigt, da diese in ihrer Wirkung nicht ausreichend genau abbildbar sind. Auch schleichende Veränderungen an Kontakten, die sich mit der Zeit ungünstig verändern und eine zunehmende Verlustleistung abgeben können, sind nicht berechenbar.

Der zunehmende elektrische Energiebedarf fordert und führt zu einer immer weiteren Ausnutzung bestehender Infrastruktureinrichtungen. Hierbei ist zu berücksichtigen, dass Infrastruktureinrichtung zur Übertragung von elektrischer Energie einer erheblichen Alterung sowie einer in vielen Teilen zunehmenden elektrischen Auslastung unterworfen ist / war und daher stellenweise den gestiegenen Anforderungen nur (noch) zum Teil mehr gerecht werden kann.

Im Bereich der Freileitungen existieren bereits Systeme, mit denen Felderfahrungen gesammelt werden. Bei Transformatoren gehört die Überwachung zum Beispiel der Temperatur zur Standardanalyse. Zur Ermittlung des thermischen Zustands von Großtransformatoren werden thermische Abbilder genutzt, da im Transformator nicht direkt an den kritischen Stellen ohne erheblichem Aufwand, allenfalls zum Beispiel mit faseroptischen Sensoren unter Rückwirkung des elektrischen Feldes, gemessen werden kann. Ebenso gilt dieses für Generatoren bzw. Energieerzeugungsanlagen.

Für den Bereich der Temperaturmessung an Kabeln existieren Verfahren als solche, die entweder über das thermische Abbild des Kabels in Verbindung mit dem Aufbringen von äußeren Messsensoren am Kabelmantel funktionieren, die die äußere Kabelmanteltemperatur erfassen und mit Hilfe einer Rechenoperation an einem zuvor ermittelten Kabeltemperaturmodel auf die Leitertemperatur zurückrechnen.

Oder, ein weiteres Verfahren im Bereich der Kabeltechnik ist das Einbringen eines Lichtwellenleiters in den Kabelmantel. Diese optische Faser ändert in Abhängigkeit der Temperatur die Polarisation des eingespeisten Laserlichts. Diese Polarisationsänderung ist proportional der Temperatur des Kabelmantels, so dass über ein thermisches Abbiid die Temperatur des Leiters errechnet wird.

Auch diese Technik zielt darauf hin, Betriebsmittel zu überwachen und optimal auszunutzen, wobei das Betriebsmittel Kabel linienhaft ausgedehnt ist und daher ein linienförmiger Messsensor benötigt wird, der in Form der Glasfaser zur Verfügung steht.

Alle elektrischen Betriebsmittel der Energieübertragung müssen i.d.R. Typprüfungen unterzogen werden, bevor diese in Einsatz gebracht werden dürfen. Diese Typprüfungen werden unter festgelegten normativen und damit vergleichbaren (Labor- und) Umgebungsbedingungen durchgeführt. Eine dieser Typprüfungen besteht in Form einer Erwärmungsprüfung, bzw. in einer Belastungsprüfung bei Nennstrom. Dabei dürfen obere Temperaturgrenzen an den verschiedenen Punkten innerhalb des Betriebsmittels nicht überschritten werden.

In der Realität schwanken jedoch die Umgebungsbedingungen, Temperaturen, relative Luftfeuchtigkeit, Verschmutzungen in erheblichem Umfang. Die einmal in der Entstehungsphase der Betriebsmittel durchgeführten Typprüfungen bilden diese Schwankungen nicht ab. Daher ergibt sich ein erhebliches zusätzlich nutzbares Potenzial bei der Auslastung der elektrischen Betriebsmittel unter Berücksichtigung der Umgebungsbedingungen. Am Beispiel des so genannten Freileitungsmonitors wird dieses sehr deutlich, dass genau diese Umstände berücksichtigt bei der Auslastung der Freileitung.

Die hier vorgeschlagenen Technologie sieht in einer Ausführung die aktuelle Erfassung der Temperatur des elektrischen Betriebsmittels an vorab definierten, kritischen Stellen wie Schraub-, Schalt-, Steckkontakten sowie Änderungen des Leiterquerschnitts vor, um damit die jeweilige Temperaturistwerte und damit den Auslastungsgrad ermitteln zu können. Bei Kabeln und Leitungen ist die linienförmige Temperaturverteilung von Bedeutung. Bei Kabeln ist die Temperaturverteilung im Erd-, bzw. Seeboden mit entscheidend. Das hier beschriebene Verfahren lässt sich auch mit linienförmigen Sensoren, zum Beispiel faseroptischen Sensoren einsetzen, so dass letztendlich keine Einschränkung bezüglich der Anwendbarkeit des hier beschriebenen Verfahrens besteht. Somit kann nahezu jedes elektrische Betriebsmittel überwacht und optimal ausgelastet werden. Ein Monitoring des aktuellen Betriebszustands ist so ermöglicht.

Die gemessenen Temperaturen sind bezüglich der maximal zulässigen Temperatur zwar aussagefähig, daraus kann aber nicht auf deren Ursache alleine zurückgeschlossen werden. In Verbindung mit der zusätzlich erfassten Strombelastung wird eine genauere Aussage möglich, ob ein fließender Strom zu einer gemessenen Temperatur passt oder ob die Umgebungstemperaturen oder die fehlende Luftströmung mit ihrer Kühlwirkung mit zu berücksichtigen sind. Letzter wird als Prozessparameter mit erfasst und mit Stromvergleichswerten verglichen.

Das hier vorgestellte Verfahren kombiniert mehrere Prozessparameter in der Art, dass eine Prozesszuordnung von aufgetretener Temperatur und Stromistwert erfolgt. Wahlweise können weiterhin zum Beispiel Erwärmungszeitkonstanten durch Parameterermittlung herangezogen werden. Mit dem Verfahren wird eine höhere Genauigkeit im Vergleich zu reinen Simulationsrechnungen erzielt. Darüber hinaus können Plausibilitätsprüfungen bezüglich der erfassten Messwerte für Temperatur und Strom erfolgen, die eine Bewertung der Messungen und den daraus ermittelten Ursachen für die Temperaturänderung erlauben.

Durch ein Temperaturmonitoring kann eine (langfristige) Veränderung von Eigenschaften des überwachten Systems erzielt werden, die eine Veränderungen der Eigenschaften bzw. ein Versagen erkennen lassen.

Eine Betriebsmitteldiagnostik zur ereignisgesteuerten Wartung und Instandhaltung ist damit ebenfalls möglich. Damit ergeben sich erhebliche Kosteneinsparungs- und Risikoreduktionspotenziale sowie eine deutlich optimierte Ausnutzung vorhandener elektrischer Betriebsmittel.

Es ist ein Verfahren geschaffen, dass neben der Temperaturmessung weitere wichtige Prozessparameter, insbesondere den Strom, sowie deren zeitlichen Verlauf miteinander in Verbindung bringt und damit Möglichkeiten eröffnet, die mit einer bislang nur angewandten Temperaturmessung erfolgten, deutlich hinausgehen. So ist es in Abhängigkeit des ermittelten Temperaturverlaufs möglich, auf die Ursache der Erwärmung zu schließen, darüber hinaus können Wartungsszenarien abgeleitet werden, Grenzwerte definiert, Überlastszenarien entwickelt und durchfahren werden, eine Auslastungsoptimierung erfolgen.

Die vorliegenden Messdaten dienen auch dazu, Zustandswerte und zum Beispiel thermische Zeitkontanten zu berechnen sowie Veränderungen dieser zu ermitteln. Abweichungen lassen eine Veränderung im System (elektrisches Betriebsmittel) oder Prozess erkennen, den es zu bewerten gilt. Daraus abgeleitet können Maßnahmen entweder hinsichtlich Wartung und Service, ggf. Instandsetzung oder die Frage der optimierten Auslastung beantwortet werden. Zugleich können mit den detaillierten Messdaten wichtige Erkenntnisse für die Weiterentwicklung von Betriebsmitteln und Prozessen im Bereich der elektrischen Energietechnik und -übertragung gewonnen werden.

Wesentliche Komponenten sind autarke Temperatursensoren sowie zum Beispiel Stromsensoren, eine entsprechende Rechentechnik sowie ein Speichersystem mit hinterlegten charakteristischen Daten (Auswerteirichtung 6) und wahlweiser Musterkennung. Das Zusammenspiel der Komponenten wird nachfolgend weitere beschrieben.

Für die Temperaturmesseinrichtung 4 sind Sensoriken als solche bekannt, die es erlauben, direkt in (Hochspannungs-, Niederspannungs-) Schaltanlagen die Temperatur auch vollkommen autark, d. h. ohne Leitungsbindung, Akku- oder Batterieversorgung zu messen.

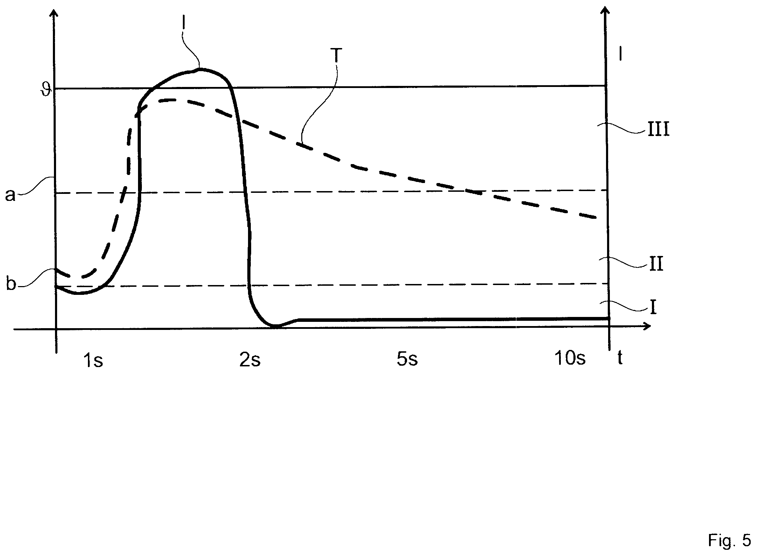

Sofern eine Zunahme der Temperatur innerhalb einer Schaltanlage oder elektrischen Betriebsmittels aufgezeichnet wird, hängt es auch zum Beispiel von der Anstiegsgeschwindigkeit ab, wie diese zu bewerten ist. Ein rascher Anstieg im Bereich von wenigen Sekunden mit Temperaturen im Bereich von einigen hundert Grad Celsius deutet auf die Übertragung eines Kurzschlusses hin und muss nicht unbedingt als gefährlicher Zustand angesehen werden, da dieses betriebsmäßig vorkommen kann (Fig. 5). In Fig. 5 wie auch den folgenden Figuren zeigen die Kurven T und I den zeitaufgelösten Verlauf für die Temperatur und den Strom.

Verbleiben jedoch die Temperaturen nach einer solchen Belastung auf einem Temperaturwert, der bei gleichem Stromwert und Umgebungstemperatur wie vor dem Kurzschlussübertragungsereignis, dann lässt sich daraus eine Änderung innerhalb der Schaltanlage oder des überwachten Betriebsmittels erkennen, die zu einer Verschlechterung oder Änderung des Zustands der Anlage / des Betriebsmittels geführt hat.

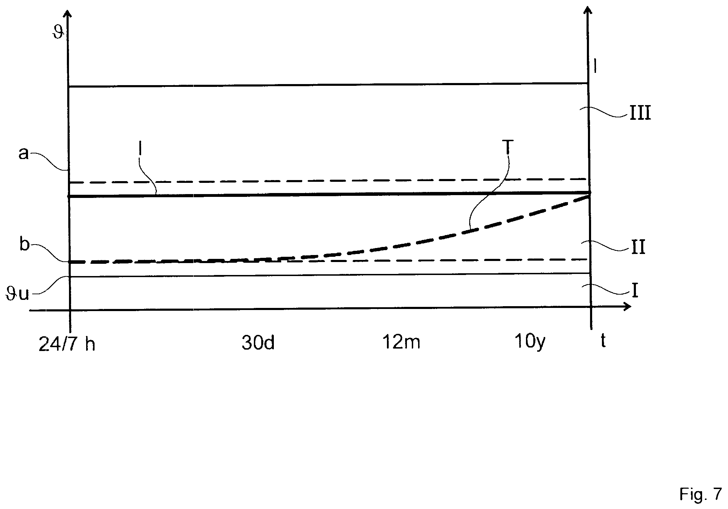

Erfolgt allerdings eine Temperaturzunahme an einer Messstelle über Jahre hinweg, wobei sich weder die Stromhöhe noch die Umgebungstemperatur geändert hat deutet diese somit auf entweder auf geänderte Strömungsverhältnisse innerhalb der Schaltanlage hin, oder es haben sich die Übergangswiderstände an Bauelementen oder Kontaktstellen geändert (Fig. 7).

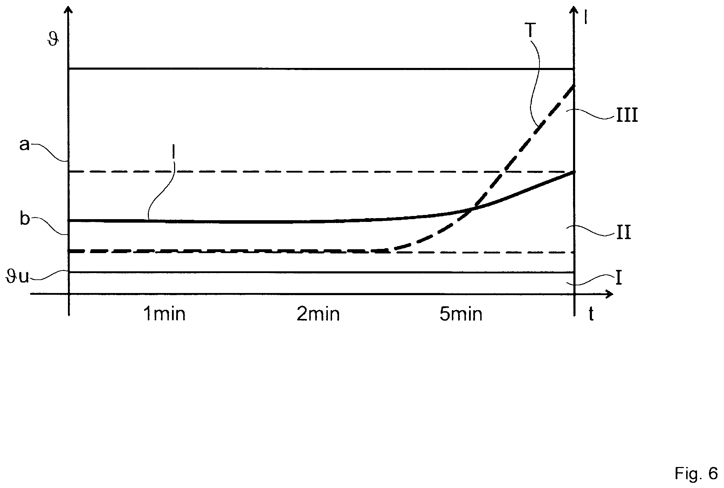

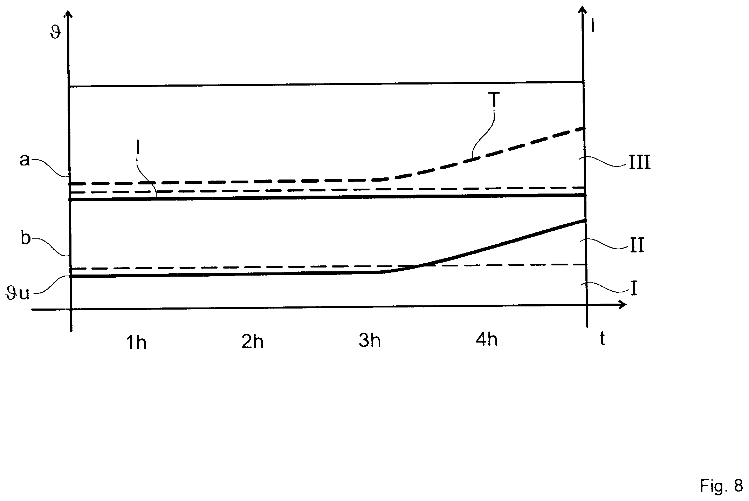

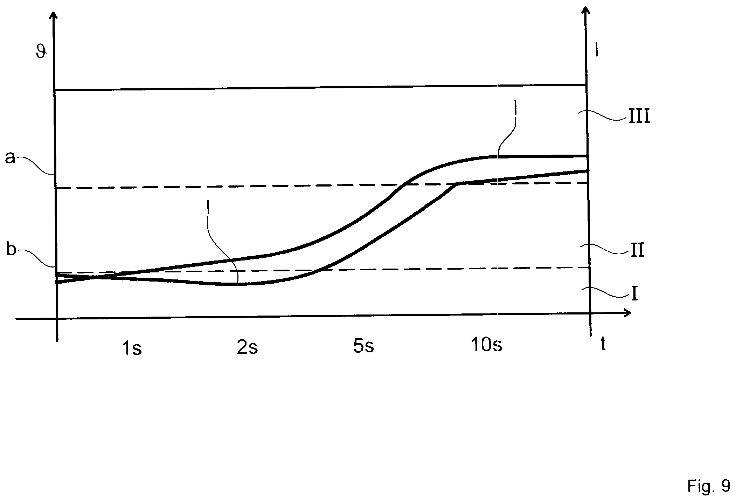

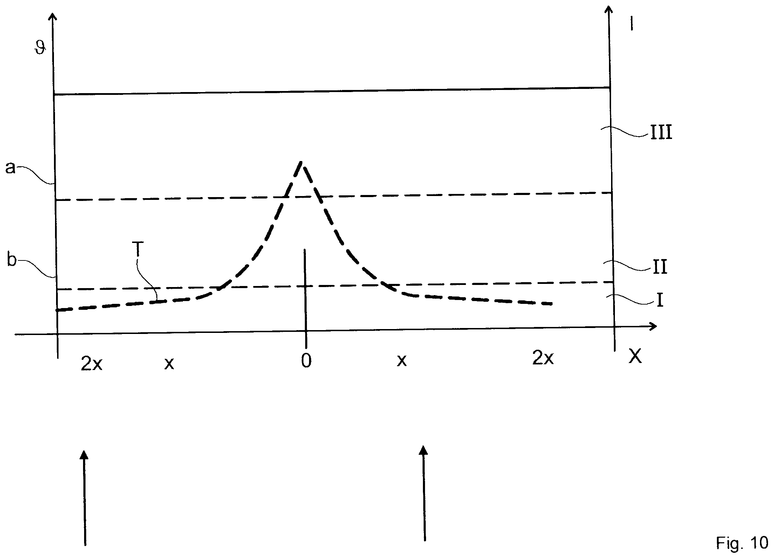

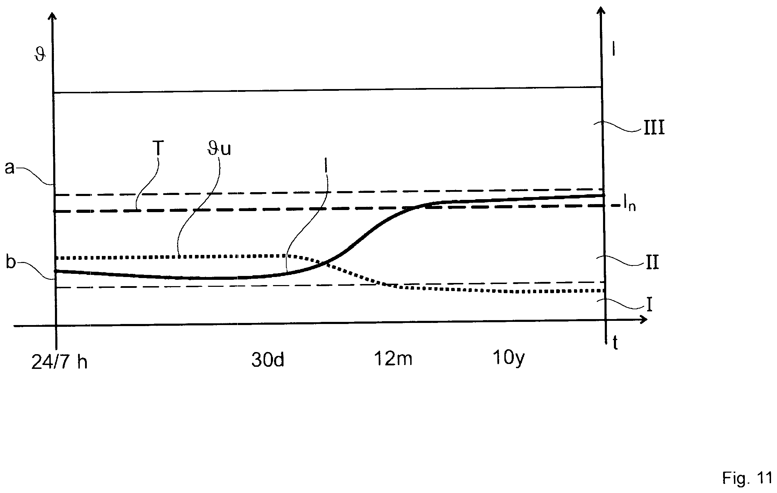

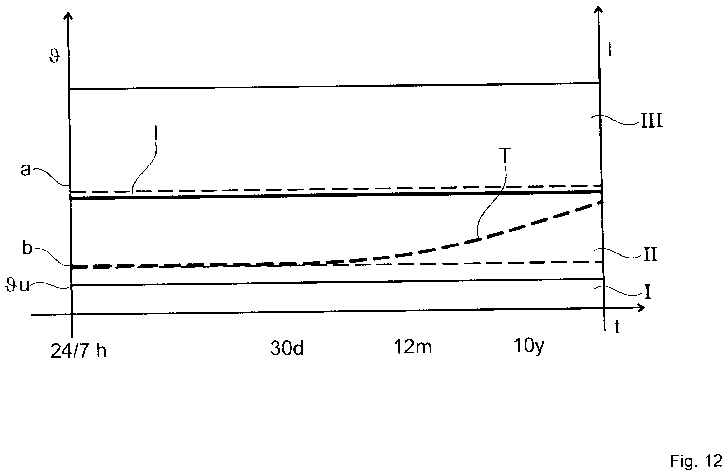

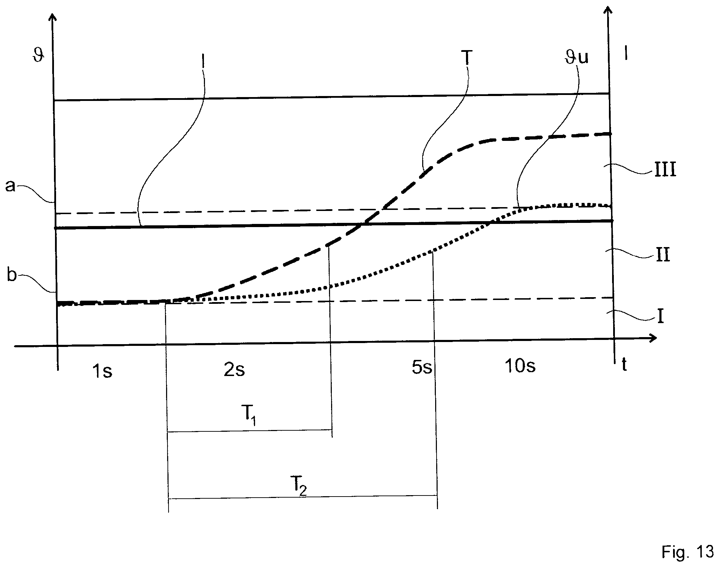

Folgende Ausführungen zeigen beispielhaft die Zusammenhänge zwischen Temperatur und Strom auf. In den grafischen Darstellungen in den Fig. 5 bis 13 bezeichnen ϑᵤ-Umgebungstemperatur, a - Warnung oder Abschaltung wegen Überschreitung eines Schwellwerts und b - Zustand erlaubt (In Ordnung). Die Bereiche I, II, III zeigen Folgendes an: I - überwachtes Betriebsmittel in erlaubtem Zustand (in Ordnung). II - für Betriebsmittel ist Temperatur angestiegen und Zustand verlangt Aufmerksamkeit (zum Beispiel Bestimmung Betriebszustand in kürzeren zeitlichen Abständen) und III - Schwell- oder Grenzwert(e) überschritten (bestimmter Betriebszustand erfordert Abschaltung des Betriebsmittels).
1. Beispiel: Kurzschluss - rascher Temperaturanstieg im Bereich von Sekunden (Fig. 5)
2. Beispiel: Anstieg der Temperatur über Jahre hinweg bei gleichem Strom - Zusetzen von Lüftungsgittern, Staubablagerungen (Fig. 12)
3. Beispiel: Anstieg der Temperatur im Inneren der Schaltanlage bei gleichem Stromwert über längerem Zeitraum hinweg. Änderung des Widerstandswerts und der Kontakttemperatur durch erhöhten Verlustleistungsumsatz. - Relation zur Umgebungstemperatur (Fig. 7)
4. Beispiel: Anstieg der Temperatur im Inneren der Schaltanlage bei hohem Stromwert - Ursache in Form eines Wirbelstromes (Fig. 6). Dieses physikalische Phänomen tritt bei größeren Strömen auf, sofern in deren Umgebung Metallteile sind, die durch Induktionswirkung einen Stromfluss zulassen.
5. Beispiel: Ausnutzung der maximal zulässigen Grenztemperaturen im Inneren der Schaltanlage durch Berücksichtigung der Umgebungstemperatur (Fig. 11). Sofern die Umgebungstemperatur absinkt kann die Verlustleistung in der Anlage gesteigert werden. Dieses kann soweit gesteigert werden, dass sogar bei sehr geringen Umgebungstemperaturen der Bemessungsstrom des Betriebsmittels überschritten werden kann ohne dass das Betriebsmittel thermisch überlastet wird, da es ja überwacht wird.
6. Beispiel: Vorausberechnung der Höhe und Dauer einer Überlastbeanspruchung in Verbindung mit Stromwerten, Ermittlung der thermischen Zeitkonstanten und Modellermittlung zur Parametervorausberechnung der sich einstellenden Temperatur, Fig. 9 in Verbindung mit Fig. 13. Sofern sich die thermischen Zeitkonstanten an einem Messpunkt ändern, auch in Kombination mit mehreren Messpunkten, oder durch die Überlagerung von thermischen Profilen, muss sich innerhalb der Schaltanlage der physikalische Zustand geändert haben. Damit tritt eine Abweichung gegenüber den bisherigen Eigenschaften auf, die bewertet und analysiert werden kann. Das Analyseergebnis führt dann zu Handlungsempfehlungen. Die hier aufgezeigten Szenarien lassen bereits auf sehr einfache Weise eine Beurteilung der Ursache einer Temperaturänderung analysieren.
   Die in Fig. 13 gezeigten Temperaturverläufe ergeben, sofern unterschiedliche thermische Zeitkonstanten T1 und T2 wirken, zum Beispiel eine Veränderung der thermischen Zeitverläufe durch Veränderungen der Strömung durch beispielweise zusetzende Lüftungsgitter oder Änderung der (mechanischen) Struktur des sich erwärmenden Objekts. Änderung des ursprünglichen Temperaturverlaufs mit der thermischen Zeitkonstante T1 zum Beispiel im Neuzustand eines Betriebsmittels aufgrund der Veränderung der Strömung hin zu dem Temperaturverlauf mit der thermischen Zeitkonstant T2.
7. Beispiel: Ermittlung der thermischen Zeitkonstanten, ggf. auch unter Berücksichtigung der räumlichen Ausdehnung und Wärmeleitung unter Berücksichtigung parasitären Effekte - Wirbelstrom, Wärmeleitung, Konvektion, Strahlung - Fig. 9, 10

Die Beispiele, welche zum teil vereinfachte Darstellungen betreffen, lassen eine Ableitung von Instandhaltungs- und Wartungsmaßnahmen zu, da der Temperaturanstieg innerhalb einer Schaltanlage einer Ursache zugeordnet werden kann. So ergibt sich, dass der Anstieg einer Temperatur bei gleichem Strom mit mindestens einem der folgenden Zustände einhergeht: durch eine veränderte Gasströmung zum Beispiel zugesetzte Lüftungsgitter; eine schleichende Zunahme des Kontaktwiderstands; Zunahme der Umgebungstemperatur und mit einer Änderung der thermischen Zeitkonstante.

Die Fälle lassen sich unterscheiden, wenn die thermischen Zeitkonstanten und / oder zum Beispiel Stromwerte berücksichtigt werden. Diese lassen unter Verwendung von Rechnertechnik leicht ermitteln und nachführen. Das dargestellte Verfahren, welches insbesondere zum thermischen Auslastungs- und Veränderungsmonitoring nutzbar ist, ist bei der Anwendung deutlich genauer als jede Simulation, da Echtdaten in Relation zueinander gesetzt werden. Ebenso können reale Strömungen innerhalb von Betriebsmitteln nicht exakt nachgebildet werden, so dass eine Abweichung zwischen Simulation und Messung bestehen bleibt. Daher ist die Verwendung des hier vorgestellten Verfahrens und der entsprechenden Sensorik als deutlich genauer und realitätsnäher anzusehen.

Die in der vorstehenden Beschreibung, den Ansprüchen sowie der Zeichnung offenbarten Merkmale können sowohl einzeln als auch in beliebiger Kombination für die Verwirklichung der verschiedenen Ausführungen von Bedeutung sein.

## Patentansprüche

1. Verfahren zum Bestimmen eines Betriebszustands eines elektrischen Betriebsmittels, mit:
- Messen von zeitabhängigen Strommesswerten für eine Stromamplitude eines elektrischen Stromflusses in einem Schaltelement (2) eines elektrischen Betriebsmittels (1);
- Messen von zeitabhängigen Temperaturmesswerten für eine Temperaturamplitude für das Schaltelement (2) und
- Bestimmen eines Betriebszustands für das elektrische Betriebsmittel (1), wobei
- die zeitabhängigen Strommesswerte mit zeitabhängigen Stromvergleichswerten verglichen werden, die jeweils mindestens einem Betriebszustand aus einer Gruppe von verschiedenen Betriebszuständen des elektrischen Betriebsmittels (1) zugeordnet sind;
- die zeitabhängigen Temperaturmesswerte mit zeitabhängigen Temperaturvergleichswerten verglichen werden, die jeweils dem mindestens einen oder mindestens einem anderen Betriebszustand aus der Gruppe von verschiedenen Betriebszuständen des elektrischen Betriebsmittels (1) zugeordnet sind; und
- ein ausgewählter Betriebszustand aus der Gruppe von verschiedenen Betriebszuständen als Betriebszustand des elektrischen Betriebsmittels (1) bestimmt wird, wenn die zeitabhängigen Strommesswerte zeitabhängigen Stromvergleichswerten und die zeitabhängigen Temperaturmesswerte zeitabhängigen Temperaturvergleichswerten entsprechen, die jeweils dem ausgewählten Betriebszustand zugeordnet sind.

2. Verfahren nach Anspruch 1, **dadurch gekennzeichnet, dass** das Messen der zeitabhängigen Temperaturmesswerte eine kontaktbehaftete Temperaturmessung an dem Schaltelement (2) aufweist.

3. Verfahren nach Anspruch 1 oder 2, **dadurch gekennzeichnet, dass** das Messen der zeitabhängigen Temperaturmesswerte eine kontaktfreie Temperaturmessung in einer Umgebung benachbart zu dem Schaltelement (2) aufweist.

4. Verfahren nach mindestens einem der vorangehenden Ansprüche, **dadurch gekennzeichnet, dass** die zeitabhängigen Strommesswerte mit simulierten zeitabhängigen Stromvergleichswerten verglichen werden, die mittels eines Simulationsmodells für das elektrische Betriebsmittel (1) bestimmt werden.

5. Verfahren nach mindestens einem der vorangehenden Ansprüche, **dadurch gekennzeichnet, dass** die zeitabhängigen Temperaturmesswerte mit simulierten zeitabhängigen Temperaturvergleichswerten verglichen werden, die mittels des Simulationsmodells für das elektrische Betriebsmittel (1) bestimmt werden.

6. Verfahren nach mindestens einem der vorangehenden Ansprüche, **dadurch gekennzeichnet, dass** der Betriebszustand eines mit einer Schaltanlage ausgeführten elektrischen Betriebsmittels (1) bestimmt wird.

7. Verfahren nach mindestens einem der vorangehenden Ansprüche, **dadurch gekennzeichnet, dass** als Betriebszustand ein Kurzschluss bestimmt wird, wenn die zeitabhängigen Temperaturmesswerte einen schnellen Temperaturanstieg anzeigen.

8. Verfahren nach mindestens einem der vorangehenden Ansprüche, **dadurch gekennzeichnet, dass** als Betriebszustand ein Wartungs- und / oder Reinigungsbedarf bestimmt wird, wenn die zeitabhängigen Temperaturmesswerte bei gleichbleibenden zeitabhängigen Strommesswerten eine Temperaturerhöhung anzeigen.

9. Verfahren nach mindestens einem der vorangehenden Ansprüche, **dadurch gekennzeichnet, dass** für eine weitere physikalische Messgröße zeitabhängige Messwerte erfasst und beim Bestimmen des Betriebszustands mit zeitabhängigen Vergleichswerten verglichen werden.

10. Anordnung, mit:
- einem elektrischen Betriebsmittel (1), welches ein Schaltelement (2) aufweist;
- einer Strommesseinrichtung (5), die eingerichtet ist, zeitabhängige Strommesswerte für eine Stromamplitude eines elektrischen Stromflusses in dem Schaltelement (2) zu erfassen;
- einer Temperaturmesseinrichtung (4), die eingerichtet ist, zeitabhängige Temperaturmesswerte für eine Temperaturamplitude für das Schaltelement (2) zu erfassen; und
- einer Auswerteinrichtung (6), die wenigstens zum Empfangen von Messdaten mit der Strommesseinrichtung (5) und der Temperaturmesseinrichtung (4) verbunden und eingerichtet ist, einen Betriebszustand für das elektrische Betriebsmittel (1) zu bestimmen, wobei
- die zeitabhängigen Strommesswerte mit zeitabhängigen Stromvergleichswerten verglichen werden, die jeweils mindestens einem Betriebszustand aus einer Gruppe von verschiedenen Betriebszuständen des elektrischen Betriebsmittels (1) zugeordnet sind;
- die zeitabhängigen Temperaturmesswerte mit zeitabhängigen Temperaturvergleichswerten verglichen werden, die jeweils dem mindestens einen oder mindestens einem anderen Betriebszustand aus der Gruppe von verschiedenen Betriebszuständen des elektrischen Betriebsmittels (1) zugeordnet sind; und
- ein ausgewählter Betriebszustand aus der Gruppe von verschiedenen Betriebszuständen als Betriebszustand des elektrischen Betriebsmittels (1) bestimmt wird, wenn die zeitabhängigen Strommesswerte zeitabhängigen Stromvergleichswerten und die zeitabhängigen Temperaturmesswerte zeitabhängigen Temperaturvergleichswerten entsprechen, die jeweils dem ausgewählten Betriebszustand zugeordnet sind.

## Claims

1. Method for determining an operating state of an electrical operating means, comprising:
- measuring time-dependent current measurement values for a current amplitude of an electrical current flow in a switching element (2) of an electrical operating means (1);
- measuring time-dependent temperature measurement values for a temperature amplitude for the switching element (2); and
- determining an operating state for the electrical operating means (1), wherein
- the time-dependent current measurement values are compared with time-dependent current comparison values which are each assigned to at least one operating state from a group of different operating states of the electrical operating means (1);
- the time-dependent temperature measurement values are compared with time-dependent temperature comparison values which are each assigned to the at least one or at least one other operating state from the group of different operating states of the electrical operating means (1); and
- a selected operating state from the group of different operating states is determined as the operating state of the electrical operating means (1) if the time-dependent current measurement values correspond to time-dependent current comparison values and the time-dependent temperature measurement values correspond to time-dependent temperature comparison values which are each assigned to the selected operating state.

2. Method according to Claim 1, **characterized in that** the measuring of the time-dependent temperature measurement values comprises a contact-based temperature measurement on the switching element (2).

3. Method according to Claim 1 or 2, **characterized in that** the measuring of the time-dependent temperature measurement values comprises a contact-free temperature measurement in an environment adjacent to the switching element (2).

4. Method according to at least one of the preceding claims, **characterized in that** the time-dependent current measurement values are compared with simulated time-dependent current comparison values which are determined by means of a simulation model for the electrical operating means (1).

5. Method according to at least one of the preceding claims, **characterized in that** the time-dependent temperature measurement values are compared with simulated time-dependent temperature comparison values which are determined by means of the simulation model for the electrical operating means (1).

6. Method according to at least one of the preceding claims, **characterized in that** the operating state of an electrical operating means (1) which is implemented with a switchgear assembly is determined.

7. Method according to at least one of the preceding claims, **characterized in that** a short circuit is determined as the operating state if the time-dependent temperature measurement values indicate a rapid temperature rise.

8. Method according to at least one of the preceding claims, **characterized in that** a maintenance and/or cleaning requirement is determined as the operating state if the time-dependent temperature measurement values indicate a temperature increase with constant time-dependent current measurement values.

9. Method according to at least one of the preceding claims, **characterized in that** time-dependent measurement values are detected for a further physical measurement variable and are compared with time-dependent comparison values when determining the operating state.

10. Arrangement, comprising:
- an electrical operating means (1) which has a switching element (2);
- a current measuring device (5) which is configured to detect time-dependent current measurement values for a current amplitude of an electrical current flow in the switching element (2);
- a temperature measuring device (4) which is configured to detect time-dependent temperature measurement values for a temperature amplitude for the switching element (2); and
- an evaluation device (6) which is connected to the current measuring device (5) and the temperature measuring device (4) at least for receiving measurement data and is configured to determine an operating state for the electrical operating means (1), wherein
- the time-dependent current measurement values are compared with time-dependent current comparison values which are each assigned to at least one operating state from a group of different operating states of the electrical operating means (1);
- the time-dependent temperature measurement values are compared with time-dependent temperature comparison values which are each assigned to the at least one or at least one other operating state from the group of different operating states of the electrical operating means (1); and
- a selected operating state from the group of different operating states is determined as the operating state of the electrical operating means (1) if the time-dependent current measurement values correspond to time-dependent current comparison values and the time-dependent temperature measurement values correspond to time-dependent temperature comparison values which are each assigned to the selected operating state.

## Revendications

1. Procédé de détermination d'un état de fonctionnement d'un appareillage électrique, comprenant :
- la mesure de valeurs de mesure de courant fonction du temps pour une amplitude de courant dans un élément de commutation (2) d'un appareillage électrique (1) ;
- la mesure de valeurs de mesure de température fonction du temps pour une amplitude de température dans l'élément de commutation (2) ; et
- la détermination d'un état de fonctionnement de l'appareillage électrique (1), dans lequel
- les valeurs de mesure de courant fonction du temps sont comparées avec des valeurs de référence de courant fonction du temps, qui sont respectivement associées à au moins un état de fonctionnement parmi un groupe de différents états de fonctionnement de l'appareillage électrique (1) ;
- les valeurs de mesure de température fonction du temps sont comparées avec des valeurs de référence de température fonction du temps, qui sont respectivement associées à au moins un ou au moins un autre état de fonctionnement parmi le groupe de différents états de fonctionnement de l'appareillage électrique (1) ; et
- un état de fonctionnement sélectionné parmi un groupe de différents états de fonctionnement est déterminé comme état de fonctionnement de l'appareillage électrique (1), lorsque les valeurs de mesure de courant fonction du temps correspondent aux valeurs de référence de courant fonction du temps et que les valeurs de mesure de température fonction du temps correspondent aux valeurs de référence de température fonction du temps, qui sont respectivement associées à l'état de fonctionnement sélectionné.

2. Procédé selon la revendication 1, **caractérisé en ce que** la mesure des valeurs de mesure de température fonction du temps comprend une mesure de température par contact au niveau de l'élément de commutation (2).

3. Procédé selon la revendication 1 ou 2, **caractérisé en ce que** la mesure des valeurs de mesure de température fonction du temps comprend une mesure de température sans contact dans un environnement adjacent à l'élément de commutation (2).

4. Procédé selon au moins une des revendications précédentes, **caractérisé en ce que** les valeurs de mesure de courant fonction du temps sont comparées à des valeurs de référence de courant simulées fonction du temps, déterminées au moyen d'un modèle de simulation de l'appareillage électrique (1).

5. Procédé selon au moins une des revendications précédentes, **caractérisé en ce que** les valeurs de mesure de température fonction du temps sont comparées à des valeurs de référence de température fonction du temps simulées, qui sont déterminées au moyen du modèle de simulation de l'appareillage électrique (1).

6. Procédé selon au moins une des revendications précédentes, **caractérisé en ce que** l'état de fonctionnement d'un appareillage électrique (1) équipé d'un ensemble de commutation est déterminé.

7. Procédé selon au moins une des revendications précédentes, **caractérisé en ce qu'**un court-circuit est déterminé comme état de fonctionnement lorsque les valeurs de mesure de température fonction du temps indiquent une augmentation rapide de la température.

8. Procédé selon au moins une des revendications précédentes, **caractérisé en ce qu'**un besoin de maintenance et/ou de nettoyage est déterminé comme état de fonctionnement, lorsque les valeurs de mesure de température fonction du temps indiquent une augmentation de la température tandis que les valeurs de mesure de courant fonction du temps restent constantes.

9. Procédé selon au moins une des revendications précédentes, **caractérisé en ce que** les valeurs de mesure fonction du temps d'une autre grandeur de mesure physique sont enregistrées et comparées à des valeurs de référence fonction du temps lors de la détermination de l'état de fonctionnement.

10. Dispositif comprenant :
- un appareillage électrique (1), qui présente un élément de commutation (2) ;
- un dispositif de mesure de courant (5), qui est configuré pour acquérir des valeurs de mesure de courant fonction du temps pour une amplitude de courant d'un courant électrique circulant dans l'élément de commutation (2) ;
- un dispositif de mesure de température (4), qui est configuré pour acquérir des valeurs de mesure de température fonction du temps pour une amplitude de température de l'élément de commutation (2) ; et
- un dispositif d'évaluation (6), qui au moins pour la réception de données de mesure est connecté au dispositif de mesure de courant (5) et au dispositif de mesure de température (4) et configuré pour déterminer un état de fonctionnement pour l'appareillage électrique (1), dans lequel
- les valeurs de mesure de courant fonction du temps sont comparées à des valeurs de référence de courant fonction du temps, qui sont respectivement associées à au moins un état de fonctionnement parmi un groupe d'états de fonctionnement différents de l'appareillage électrique (1) ;
- les valeurs de mesure de température fonction du temps sont comparées avec des valeurs de référence de température fonction du temps, qui sont respectivement associées à au moins un ou au moins un autre état de fonctionnement parmi le groupe de différents états de fonctionnement de l'appareillage électrique (1) ; et
- un état de fonctionnement sélectionné parmi un groupe de différents états de fonctionnement est déterminé comme état de fonctionnement de l'appareillage électrique (1), lorsque les valeurs de mesure de courant fonction du temps correspondent aux valeurs de référence de courant fonction du temps et que les valeurs de mesure de température fonction du temps correspondent aux valeurs de référence de température fonction du temps, qui sont respectivement associées à l'état de fonctionnement sélectionné.
